(19) 

Europäisches
Patentamt
European
Patent Office
Office européen
des brevets

(11) **EP 2 434 530 A2**

(12) **EUROPEAN PATENT APPLICATION**

(43) Date of publication:
   **28.03.2012 Bulletin 2012/13**

(51) Int Cl.:
   **H01L 21/02** (2006.01)     **H01L 27/06** (2006.01)
   **H01L 27/01** (2006.01)

(21) Application number: **11173115.4**

(22) Date of filing: **07.07.2011**

(84) Designated Contracting States:
   **AL AT BE BG CH CY CZ DE DK EE ES FI FR GB
   GR HR HU IE IS IT LI LT LU LV MC MK MT NL NO
   PL PT RO RS SE SI SK SM TR**
   Designated Extension States:
   **BA ME**

(30) Priority: **28.09.2010 JP 2010217317**

(71) Applicant: **Renesas Electronics Corporation**
   **Nakahara-ku**
   **Kawasaki**
   **Kanagawa 211-8668 (JP)**

(72) Inventors:
   • **Sekine, Yasushi**
     **Hyogo, 664-0005 (JP)**
   • **Yamagata, Tadato**
     **Kanagawa, 211-8668 (JP)**

(74) Representative: **Calderbank, Thomas Roger et al**
   **Mewburn Ellis LLP**
   **33 Gutter Lane**
   **London**
   **EC2V 8AS (GB)**

(54) **Integrated resistor with titanium nitride and tantalum nitride resistance elements**

(57)     There is provided a semiconductor device having resistance elements small in temperature dependence of the resistance value. The semiconductor device has two metal resistance element layers (Rm1,Rm2). Each metal resistance element layer includes a resistance film layer (Rm12,Rm11). One of the metal resistance film layers is of titanium nitride and the other one of tantalum nitride. The resistance value of titanium nitride has a positive temperature coefficient. Whereas, the resistance value of tantalum nitride has a negative temperature coefficient. A contact plug (P2) electrically couples the metal resistance film layers with each other. Therefore, the temperature coefficient of the titanium nitride and the temperature coefficient of the tantalum nitride cancel each other.

FIG. 8

EP 2 434 530 A2

**Description**

The disclosure of Japanese Patent Application No. 2010-217317 filed on September 28, 2010 including the specification, drawings and abstract is incorporated herein by reference in its entirety.

The present invention relates to a semiconductor device. More particularly, it relates to a configuration of a resistance element included in a semiconductor device.

In the related art, a microcomputer and an oscillator have been separately manufactured. In recent years, inclusion of an oscillator in a chip of a microcomputer has achieved shrinkage of the layout area of a semiconductor device, reduction of the cost, and the like.

In order for a chip of a microcomputer to include an oscillator therein, the oscillation frequency of the oscillator is required to be stable even when the conditions such as voltage and temperature change. As one example, for a high-speed OCO (On Chip Oscillator) circuit included in a microcomputer, the oscillation frequency is required to be, for example, 40 MHz $\pm$ 1 %.

The high-speed OCO circuit includes, for example, a resistance element for converting the current supplied from a constant current source into a voltage. The voltage determines the oscillation frequency. Therefore, when the resistance value of the resistance element varies according to the temperature, the oscillation frequency of the high-speed OCO circuit varies. For this reason, the temperature dependence of the resistance value of the resistance element is required to be reduced.

For example, Japanese Unexamined Patent Publication No. 2007-149965 (Patent Literature 1), and Japanese Unexamined Patent Publication No. 2006-216607 (Patent Literature 2) disclose a technology of inhibiting the temperature dependence of the resistance value by combining a resistance element having a positive temperature coefficient and a resistance element having a negative temperature coefficient. Patent Literature 1 discloses the following: the resistance value of a resistance element formed of nickel chromium has a positive temperature coefficient, and the resistance value of a resistance element formed of chromium silicon has a negative temperature coefficient. Patent Literature 2 discloses the following: the resistance value of a resistance element formed of N type polysilicon has a positive temperature coefficient, and the resistance value of a resistance element formed of P type polysilicon has a negative temperature coefficient.

[Citation List]

[Patent Literature 1]
Japanese Unexamined Patent Publication No. 2007-149965
[Patent Literature 2]
Japanese Unexamined Patent Publication No. 2006-216607

Patent Literature 1 does not specifically disclose the temperature coefficient of the resistance value. Accordingly, Patent Literature 1 does not specifically disclose how much the temperature change rate of the resistance value of the resistance element including a nickel chromium resistance and a chromium silicon resistance is reduced.

On the other hand, Patent Literature 2 discloses that the change rate of the resistance value of the resistance element formed of N type polysilicon and P type polysilicon is -0.02 % (within the temperature range of -45 °C to 125 °C). In the case of a circuit required to have a resistance element having a high-precision resistance value as with the high-speed OCO circuit, the temperature dependence of the resistance value is required to be as small as possible. Therefore, the resistance element formed of N type polysilicon and P type polysilicon may be inapplicable to such a circuit.

It is a preferred aim of the present invention to provide a semiconductor device having a resistance element whose resistance value may show a small temperature dependence.

A semiconductor device in accordance with one example of the present invention includes a semiconductor substrate, an insulation layer provided over the semiconductor substrate, a first resistance element provided over the insulation layer, and a second resistance element electrically coupled with the first resistance element. One of the first and second resistance elements is formed of titanium nitride. The other of the first and second resistance elements is formed of tantalum nitride.

In accordance with examples of the present invention, it is possible to provide a semiconductor device having a resistance element whose resistance value shows a small temperature dependence.

In the drawings:

FIG. 1 is a schematic view showing an overall structure of a microcomputer chip including a semiconductor device in accordance with an embodiment of the present invention;

FIG. 2 is a circuit diagram showing one example of a configuration of a high-speed OCO circuit shown in FIG. 1;

FIG. 3 is a view showing the temperature dependence of the resistance value of a titanium nitride resistance;

FIG. 4 is a view showing the temperature dependence of the resistance value of a tantalum nitride resistance;

FIG. 5 is a view showing the temperature dependence of a resistance element in accordance with a first embodiment;

FIG. 6 is an equivalent circuit diagram of the resistance element of the first embodiment;

FIG. 7 is a plan view of the resistance element in accordance with the first embodiment;

FIG. 8 is a cross-sectional view along line VIII-VIII of FIG. 7;

FIG. 9 is a cross-sectional view schematically showing an example of a semiconductor device having the simplest multilayer interconnection structure;

FIG. 10 is a schematic cross-sectional view showing a first step of a method for manufacturing a semiconductor device in accordance with the first embodiment;

FIG. 11 is a schematic cross-sectional view showing a second step of the method for manufacturing the semiconductor device in accordance with the first embodiment;

FIG. 12 is a schematic cross-sectional view showing a third step of the method for manufacturing the semiconductor device in accordance with the first embodiment;

FIG. 13 is a schematic cross-sectional view showing a fourth step of the method for manufacturing the semiconductor device in accordance with the first embodiment;

FIG. 14 is a schematic cross-sectional view showing a fifth step of the method for manufacturing the semiconductor device in accordance with the first embodiment;

FIG. 15 is a schematic cross-sectional view showing a sixth step of the method for manufacturing the semiconductor device in accordance with the first embodiment;

FIG. 16 is a schematic cross-sectional view showing a seventh step of the method for manufacturing the semiconductor device in accordance with the first embodiment;

FIG. 17 is a schematic cross-sectional view showing an eighth step of the method for manufacturing the semiconductor device in accordance with the first embodiment;

FIG. 18 is a schematic cross-sectional view showing a ninth step of the method for manufacturing the semiconductor device in accordance with the first embodiment;

FIG. 19 is a schematic cross-sectional view showing a tenth step of the method for manufacturing the semiconductor device in accordance with the first embodiment;

FIG. 20 is a schematic cross-sectional view showing an eleventh step of the method for manufacturing the semiconductor device in accordance with the first embodiment;

FIG. 21 is a schematic cross-sectional view showing a twelfth step of the method for manufacturing the semiconductor device in accordance with the first embodiment;

FIG. 22 is a schematic cross-sectional view showing a thirteenth step of the method for manufacturing the semiconductor device in accordance with the first embodiment;

FIG. 23 is a plan view showing a first modified example of the resistance element in accordance with the first embodiment;

FIG. 24 is a cross-sectional view along line XXIV-XXIV of FIG. 23

FIG. 25 is a plan view showing a second modified example of the resistance element in accordance with the first embodiment;

FIG. 26 is an equivalent circuit diagram of a resistance element of a second embodiment;

FIG. 27 is a plan view showing one example of the resistance element in accordance with the second embodiment;

FIG. 28 is a cross-sectional view along line XXVIII-XXVIII of FIG. 27

FIG. 29 is a cross-sectional view along line XXIX-XXIX of FIG. 27;

FIG. 30 is a cross-sectional view along line XXX-XXX of FIG. 27;

FIG. 31 is a plan view showing one example of a resistance element in accordance with a third embodiment;

FIG. 32 is a cross-sectional view along line XXXII-XXXII of FIG. 31

FIG. 33 is a cross-sectional view along line XXXIII-XXXIII of FIG. 31;

FIG. 34 is a cross-sectional view showing another example of the resistance element in accordance with the third embodiment; and

FIG. 35 is a view showing a resistance circuit included in a semiconductor device in accordance with a fourth embodiment.

Below, embodiments of the present invention will be described in details by reference to the accompanying drawings. Incidentally, in the drawings, the same or similar parts are given the same reference numerals and signs, and a description thereon will not be repeated.

First Embodiment

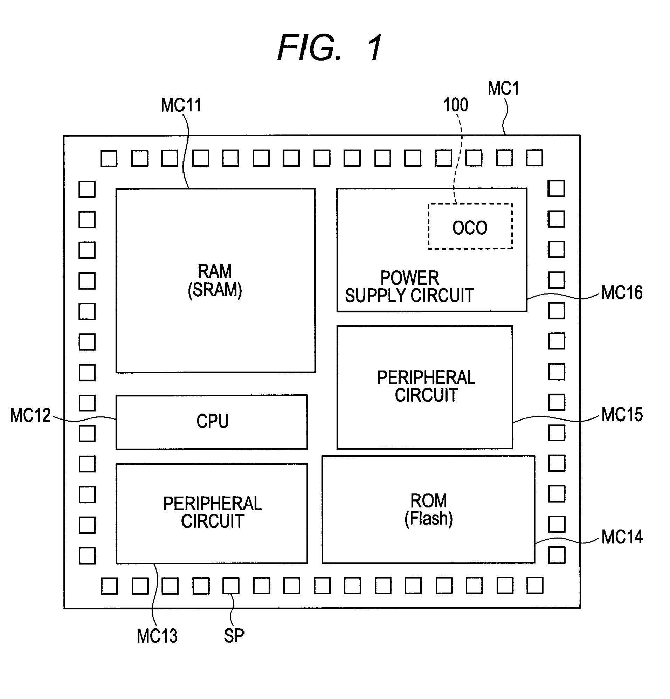

FIG. 1 is a schematic view showing the overall structure of a microcomputer chip including a semiconductor device in accordance with an embodiment of the present invention.

Referring to FIG. 1, a microcomputer chip MC1 includes a RAM (Random Access Memory) formation region MC11, a CPU (Central Processing Unit) formation region MC12, peripheral circuit formation regions MC13 and MC15, a ROM (Read Only Memory) formation region MC14, and a power supply circuit region MC16. The power supply circuit region MC16 includes a high-speed OCO circuit 100. The layout shown in FIG. 1 is one example, and the configuration of the microcomputer chip is not limited as shown in FIG. 1.

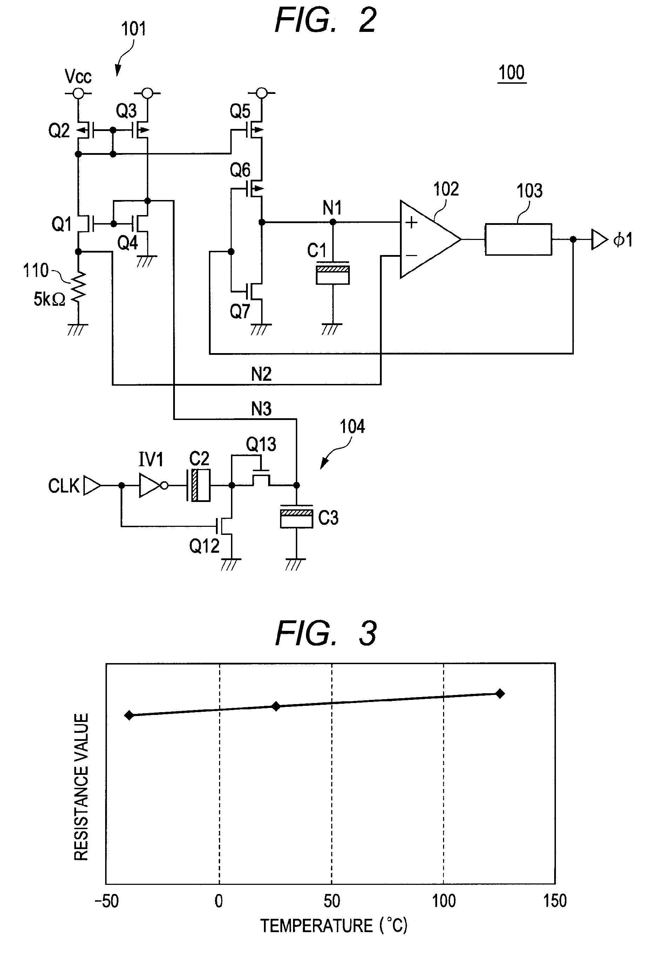

FIG. 2 is a circuit diagram showing one example of the configuration of the high-speed OCO circuit shown in FIG. 1. Referring to FIG. 2, the high-speed OCO circuit 100 generates a signal having a prescribed oscillation period (although not particularly limited, for example, 40 MHz) by, for example, the oscillation operation due to repetition of charging and discharging of a capacitance element.

The high-speed OCO circuit 100 includes a constant voltage circuit 101 including a constant current source. The constant voltage circuit 101 includes a depression type MOSFET Q1, a resistance element 110, and enhancement type MOSFETs Q2, Q3, and Q4. The MOSFETs Q1 and Q4 are N channel MOSFETs. The MOSFETs Q2 and Q3 are P channel MOSFETs. The high-speed OCO circuit 100 further includes enhancement type MOSFETs Q5 to Q7, a capacitor C1, a differential amplification circuit 102, a delay circuit 103, and a booster circuit 104.

The source of the MOSFET Q1 is coupled to one end of the resistance element 110. The drain of the MOSFET Q1 and the drain of the MOSFET Q2, and the gate of the MOSFET Q2 and the gate of the MOSFET Q3 are mutually coupled. The drain of the MOSFET Q3 and the drain of the MOSFET Q4, and the gate of the MOSFET Q4 and the gate of the MOSFET Q1 are mutually coupled. The sources of the MOSFETs Q2 and Q3 are coupled to a source voltage Vcc. The other end of the resistance element 110 and the source of the MOSFET Q4 are coupled to the grounding voltage.

The constant voltage circuit 101 generates a given current flowing through the resistance element 110. From one end (node N) of the resistance element 110, there is outputted a constant voltage determined by the product of the current value and the resistance value (as one example, 5 kΩ) of the resistance element 110. The constant voltage is the reference voltage to be inputted to the negative input terminal of the differential amplification circuit 102.

The gate of the MOSFET Q5 is coupled to the gate of the MOSFET Q2 and the gate of the MOSFET Q3. The source of the MOSFET Q5 is coupled to the source voltage Vcc. The drain of the MOSFET Q5 is coupled to the source of the MOSFET Q6. The drain of the MOSFET Q6 is coupled to the drain of the MOSFET Q7. The source of the MOSFET Q7 is coupled to the grounding voltage.

The gate of the MOSFET Q6 and the gate of the MOSFET Q7 are coupled to the output terminal of the delay circuit 103. The drain of the MOSFET Q6 and the drain of the MOSFET Q7 are both coupled to one end (node N1) of the capacitor C1, and coupled to the positive input terminal of the differential amplification circuit 102.

The differential amplification circuit 102 compares the voltage generated by the constant voltage circuit 101 and the voltage of the capacitor C1. The capacitor C1 is charged or discharged according to the comparison result. By repetition of charging and discharging of the capacitor C1, a signal having a prescribed oscillation period is outputted via the delay circuit 103.

The booster circuit 104 includes an inverter IV1, enhancement type MOSFETs Q12 and Q13, and capacitors C2 and C3. The MOSFETs Q12 and Q13 are N channel MOSFETs.

A start signal CLK is inputted into the booster circuit 104. The booster circuit 104 boosts the voltage of the start signal CLK, and applies the boosted voltage to the gate of the MOSFET Q4 and the gate of the MOSFET Q1.

The start signal CLK is inputted to the inverter IV1 and the gate of the MOSFET Q12. The output terminal of the inverter IV1 is coupled to one end of the capacitor C2. The other end of the capacitor C2 is coupled to the drain of the MOSFET Q12, the drain of the MOSFET Q13, and the gate of the MOSFET Q13. The source of the MOSFET Q13 is coupled to one end (node N3) of the capacitor C3. The source of the MOSFET Q12 and the other end of the capacitor C3 are coupled to the grounding voltage.

The voltage outputted from the constant voltage circuit 101 is determined by the resistance value of the resistance element 110 and the current flowing through the resistance element 110. In accordance with the embodiment of this invention, it becomes possible to inhibit variation in resistance value of the resistance element 110 according to the temperature. Therefore, it is possible to stabilize the voltage outputted from the constant voltage circuit 101. Stabilization of the voltage outputted from the constant voltage circuit 101 can stabilize the oscillation frequency of the signal outputted from the high-speed OCO circuit (e.g., 40 MHz ± 1% or 40 MHz ± 0.2%). Namely, it is possible to stabilize the frequency of the oscillation circuit included in the chip of the microcomputer.

In order to prevent the resistance value from varying according to the temperature, in the related art, the resistance element 110 includes, for example, a combination of N type polysilicon and P type polysilicon. The resistance value of N type polysilicon has a positive temperature coefficient. In contrast, the resistance value of P type polysilicon has a negative temperature coefficient. Combination of both causes the positive temperature coefficient and the negative temperature coefficient to cancel each other. Therefore, it is possible to reduce the temperature coefficient of the resistance value.

However, the temperature coefficient of polysilicon is generally about several thousand ppm. Further, the temperature coefficient of polysilicon is adjusted by the impurity concentration of polysilicon. For this reason, it is difficult to form a polysilicon resistance having a small temperature coefficient with stability.

Thus, it is considered that the resistance element 110 is formed of a metal material whose resistance value shows a small variation within the compensated temperature range of the semiconductor device. For example, by using titanium nitride (TiN) for the resistance element 110, it is possible to achieve a temperature coefficient (several hundred ppm) one order of magnitude smaller than the temperature coefficient of the polysilicon resistance.

However, when the precision of the oscillation frequency is required to be further enhanced, a resistance having a smaller temperature coefficient may be demanded. In accordance with the embodiment of the present invention, combination of a titanium nitride resistance and a tantalum nitride (TaN) resistance forms the resistance element 110.

FIG. 3 is a view showing the temperature dependence of the resistance value of the titanium nitride resistance. Referring to FIG. 3, the resistance value of the titanium nitride resistance has a positive temperature coefficient (about several hundred ppm, e.g., 400 ppm) within the temperature range of -40 °C to 125 °C. Incidentally, the temperature range is one example.

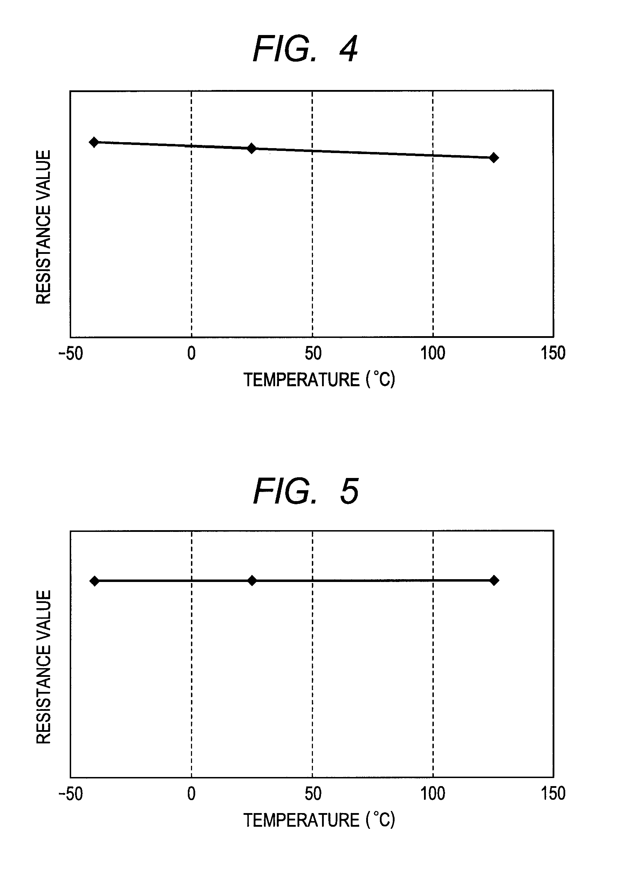

FIG. 4 is a view showing the temperature dependence of the resistance value of the tantalum nitride resistance. Referring to FIG. 4, the resistance value of the tantalum nitride resistance has a negative temperature coefficient (the absolute value is about several hundred ppm) within the temperature range of -40 °C to 125 °C.

FIG. 5 is a view showing the temperature dependence of the resistance element in accordance with the first embodiment. Referring to FIG. 5, the resistance element in accordance with the first embodiment has mutually electrically coupled titanium nitride resistance and tantalum nitride resistance. In the resistance element, the temperature coefficient of the titanium nitride resistance and the temperature coefficient of the tantalum nitride resistance cancel each other. Therefore, it is possible to make smaller the absolute value of the temperature coefficient, or to make zero the temperature coefficient.

The temperature coefficient of the resistance value of the titanium nitride resistance and the temperature coefficient of the resistance value of the tantalum nitride resistance (absolute values) are both about one order of magnitude smaller than the temperature coefficient of the resistance value of the polysilicon resistance. Therefore, it becomes possible to form a resistance element having a small temperature coefficient with stability.

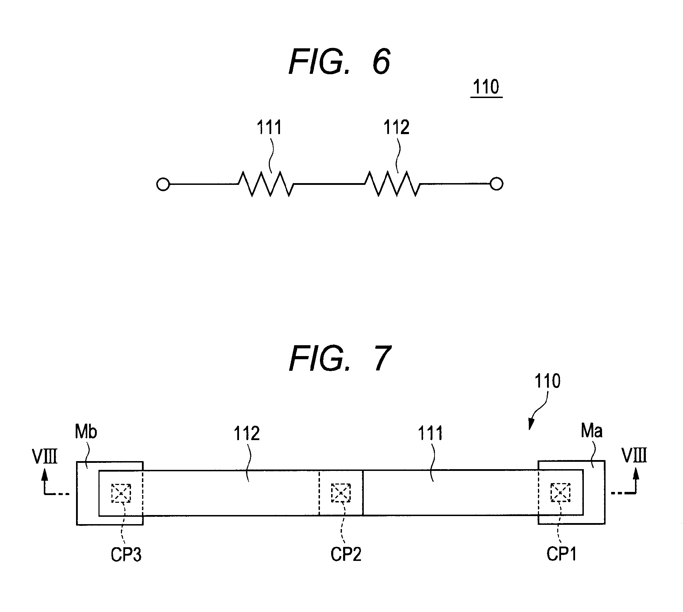

FIG. 6 is an equivalent circuit diagram of the resistance element in accordance with the first embodiment. Referring to FIG. 6, the resistance element 110 includes mutually series-coupled resistance elements 111 and 112. The resistance element 111 is one of the titanium nitride resistance and the tantalum nitride resistance. The resistance element 112 is the other of the titanium nitride resistance and the tantalum nitride resistance.

The resistance value of the resistance element 111 is referred to as R1. The resistance value of the resistance element 112 is referred to as R2. The resistance value R of the resistance element 110 is expressed according to the following expression (1) (the sign "*" represents the product; the same applies to the following).

$$R=R1+R2=R1s(1+\Delta R1)+R2s(1+\Delta R2)=R1s+R2s+\Delta R1*R1s+\Delta R2*R2s$$

$$...(1)$$

where $\Delta R1$ and $\Delta R2$ are values having mutually opposite signs. For example, it is assumed that the resistance element 111 is a titanium nitride resistance, and that the resistance element 112 is a tantalum nitride resistance. In this case, $\Delta R1$ is a positive value, and $\Delta R2$ is a negative value. By appropriately setting the resistance values R1 and R2, it is possible to make $\Delta R1*R1s+\Delta R2*R2s$ to be zero. R1s and R2s are temperature-independent components. When $\Delta R1*R1s+\Delta R2*R2s=0$, it is possible to obtain a temperature-independent resistance value R (=R1s+R2s).

The relationship between $\Delta R1$ and $\Delta R2$ is previously determined experimentally or by other methods. As a result, the relationship between R1s and R2s for obtaining $\Delta R1*R1s+\Delta R2*R2s=0$ is determined. The resistance value R is determined at the stage of, for example, circuit design. The resistance value R (design value) , and the relationship between R1s and R2s determine the resistance values R1s and R2s. Accordingly, the values of the resistance values R1s and R2s are defined as resistance values R1 and R2, respectively. By appropriately setting respective widths, lengths, and thicknesses of the titanium nitride resistance and the tantalum nitride resistance, it is possible to obtain the resistance values.

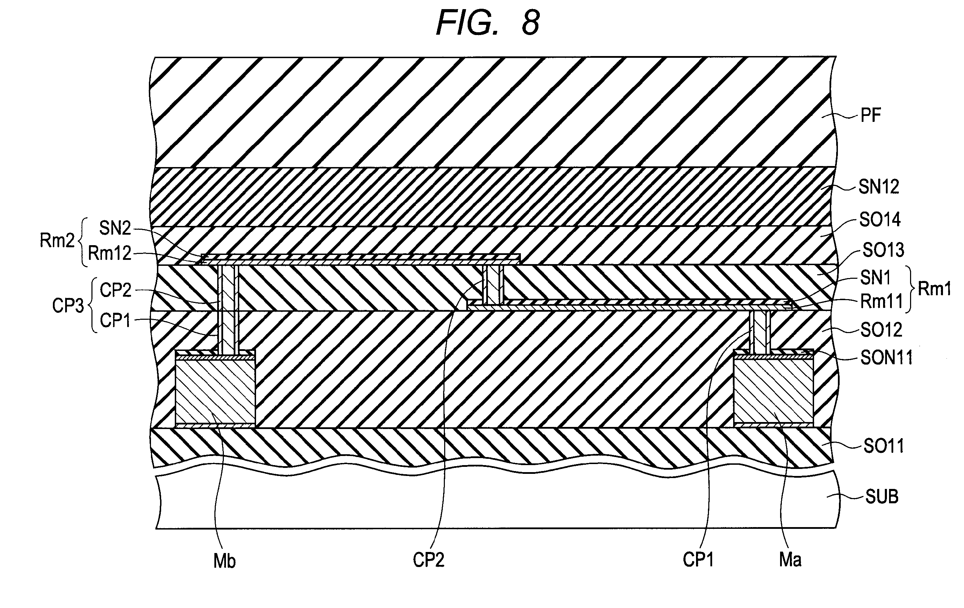

FIG. 7 is a plan view of the resistance element in accordance with the first embodiment. FIG. 8 is a cross-sectional view along line VIII-VIII of FIG. 7.

Referring to FIGS. 7 and 8, the semiconductor device has a substrate SUB, and a first interlayer insulation film SO11 provided over the substrate SUB. Over the first interlayer insulation film SO11, tap layers Ma and Mb are provided. To the layer underlying the first interlayer insulation film SO11, a multilayer interconnection structure is applied. The tap layers Ma and Mb are wiring layers arranged at the highest position of a plurality of wiring layers.

The tap layers Ma and Mb are covered with a surface-planarized second interlayer insulation film SO12. Over the second interlayer insulation film SO12, a metal resistance element layer Rm1 is provided. The metal resistance element layer Rm1 has a double-layer structure of a metal resistance film layer Rm11 and an antioxidant film layer SN1. The metal resistance element layer Rm1 corresponds to the resistance element 111.

The metal resistance element layer Rm1 is covered with a surface-planarized third interlayer insulation film SO13. Over the third interlayer insulation film SO13, a metal resistance element layer Rm2 is provided. The metal resistance element layer Rm2 has a double-layer structure of a metal resistance film layer Rm12 and an antioxidant film layer SN2. The metal resistance element layer Rm2 corresponds to the resistance element 112.

The metal resistance element layer Rm2 is covered with a surface-planarized fourth interlayer insulation film SO14. The fourth interlayer insulation film SO14 is covered with a flat-surface passivation film SN12. The passivation film SN12 is covered with a flat-surface protective film PF.

The metal resistance film layer Rm11 is one of the titanium nitride resistance and the tantalum nitride resistance. The metal resistance film layer Rm12 is the other of the titanium nitride resistance and the tantalum nitride resistance. Namely, at a layer arranged above the layer of the tantalum nitride resistance, the titanium nitride resistance may be formed. Conversely, at a layer arranged above the layer of the titanium nitride resistance, the tantalum nitride resistance may be formed.

A contact plug CP1 couples the one end of the resistance element 111 and the tap layer Ma. A contact plug CP2 couples the other end of the resistance element 111 and the one end of the resistance element 112. A contact plug CP3 couples the other end of the resistance element 112 and the tap layer Mb. For the contact plugs CP1 to CP3, for example, tungsten (W) is used. The contact plug CP3 includes the contact plug CP1, and the contact plug CP2 coupled to the contact plug CP1.

The material for the contact plugs CP1 to CP3 is different from any of titanium nitride and tantalum nitride. Therefore, conceivably, the temperature characteristics of the resistance values of the contact plugs CP1 to CP3 may affect the temperature characteristics of the resistance value of the resistance element 110. When each of the contact plugs CP1 to CP3 is formed of tungsten as described above, the temperature coefficient of the resistance value of tungsten is about several thousand ppm (e.g., 3000 ppm). However, by increasing the proportion of contribution of the resistance value of the resistance element 110 to the overall resistance value of total of the resistance value of the resistance element 110, and the resistance values of the contact plugs CP1 to CP3, it is possible to reduce the variation in resistance value due to the temperature characteristics of the resistance values of the contact plugs CP1 to CP3.

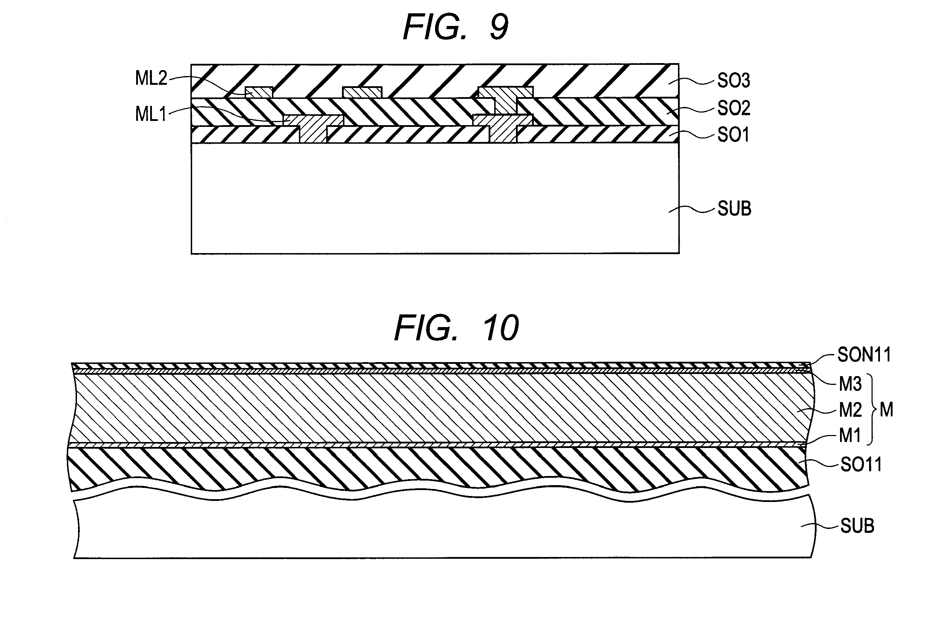

FIG. 9 is a cross-sectional view schematically showing an example of a semiconductor device having the simplest multilayer interconnection structure. Referring to FIG. 9, over the substrate SUB, an insulation film SO1 is formed. Over the insulation film SO1, a wiring layer ML1 is formed. The wiring layer ML1 is covered with an insulation film SO2. Over the insulation film SO2, a wiring layer ML2 is formed. The wiring layer ML2 is covered with an insulation film SO3. In accordance with the configuration shown in FIG. 9, the wiring layer ML2 is a wiring layer arranged at the highest position of a plurality of wiring layers. Therefore, the metal resistance element layers Rm1 and Rm2 are formed at a position above the wiring layer ML2, for example, over the insulation film SO3.

In the case of a semiconductor device having a multilayer interconnection structure, the number of wiring layers is not limited to two so long as it is plural. Namely, the number of wiring layers arranged below the tap layers Ma and Mb shown in FIG. 8 has no particular restriction so long as it is 1 or more.

Then, a description will be given to a method for manufacturing the semiconductor device in accordance with the first embodiment. Specifically, a description will be given to a manufacturing step of the resistance element 110 shown in FIGS. 7 and 8.

FIG. 10 is a schematic cross-sectional view showing a first step of the method for manufacturing the semiconductor device in accordance with the first embodiment. Referring to FIG. 10, over the substrate SUB, a known multilayer interconnection structure is formed. Then, a surface-planarized first interlayer insulation film SO11 is formed. For the first interlayer insulation film SO11, a silicon oxide film is used. For the silicon oxide film, there are used an USG (Undoped Silicate Glass) film deposited by a High Density Plasma CVD method with a good step coverage (HDP-USG) and a TEOS film deposited by a plasma CVD method (P-TEOS). The substrate SUB is a semiconductor substrate, and circuit elements such as transistors (not shown) are formed over the substrate SUB.

Then, over the first interlayer insulation film SO11, a wiring layer M is formed. The wiring layer M is a wiring layer arranged at the highest position of a plurality of wiring layers. The wiring layer M is deposited by a sputtering method. The wiring layer M has a lower layer M1, a wiring main body M2, and an upper layer M3. The lower layer M1 includes a TiN/Ti film. The wiring main body M2 includes a copper-added aluminum (Al-Cu) film. The upper layer M3 includes a TiN/Ti film. The film thickness of the wiring layer M is, for example, about several hundred nm to 1 $\mu$m.

Then, over the wiring layer M, an antireflective film SON11 is formed. The antireflective film SON11 is, for example, a plasma oxynitride film (P-SiON), and is formed by a CVD method.

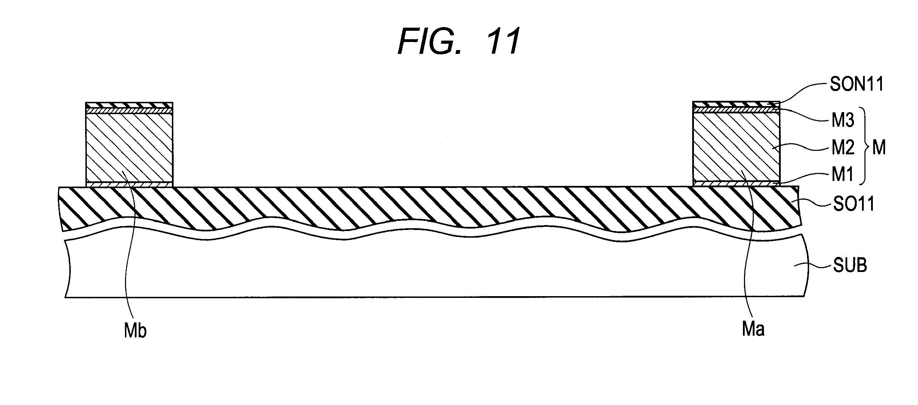

FIG. 11 is a schematic cross-sectional view showing a second step of the method for manufacturing the semiconductor device in accordance with the first embodiment. Referring to FIG. 11, patterning of the wiring layer M and the antireflective film SON11 is performed. For patterning, a photolithographic technology and a dry etching treatment are used. The tap layers Ma and Mb are formed by patterning. Incidentally, known technologies are applicable to the photolithographic technology and the dry etching treatment for patterning. Therefore, herein, a detailed description thereon will not be repeated (the same applies to the following description).

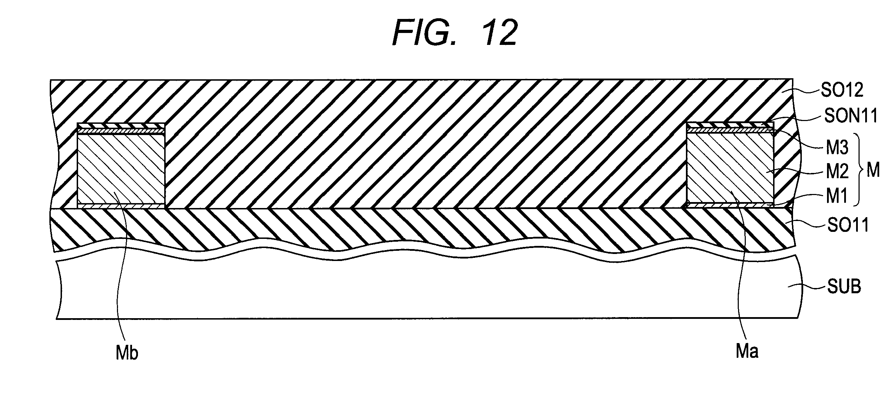

FIG. 12 is a schematic cross-sectional view showing a third step of the method for manufacturing the semiconductor device in accordance with the first embodiment. Referring to FIG. 12, the second interlayer insulation film SO12 covering the tap layers Ma and Mb is formed. For the second interlayer insulation film SO12, a silicon oxide film including HDP-USG and P-TEOS is used. A planarization treatment using a CMP (Chemical Mechanical Polishing) method is performed. As a result, the surface of the second interlayer insulation film SO12 is planarized.

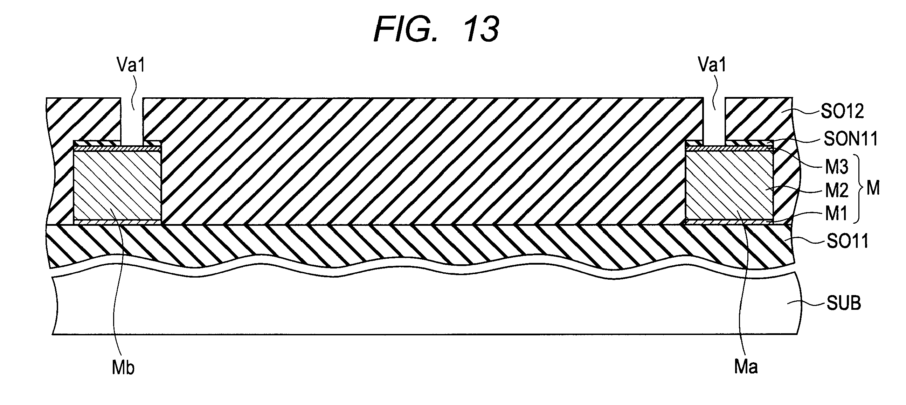

FIG. 13 is a schematic cross-sectional view showing a fourth step of the method for manufacturing the semiconductor device in accordance with the first embodiment. Referring to FIG. 13, using a photolithographic technology and a dry etching treatment, contact holes Va1 respectively communicating with the tap layers Ma and Mb are formed in the second interlayer insulation film SO12.

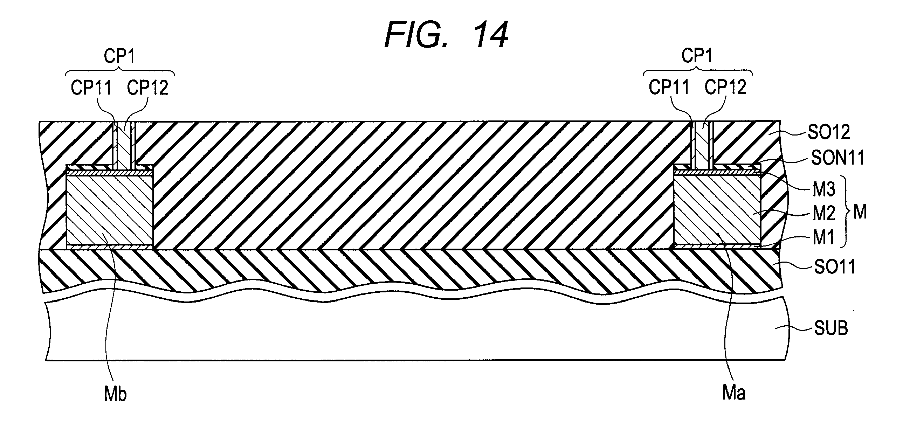

FIG. 14 is a schematic cross-sectional view showing a fifth step of the method for manufacturing the semiconductor device in accordance with the first embodiment. Referring to FIG. 14, in each contact hole Va1, a contact plug CP1 is formed First, a TiN/Ti (titanium) lamination film CP11 as a barrier metal is deposited in the contact hole Va1 by a sputtering method. Then, a tungsten film CP12 is deposited by a CVD method. Subsequently, by a CMP method, the top surfaces of the TiN/Ti lamination film CP11 and the tungsten film CP12 are planarized.

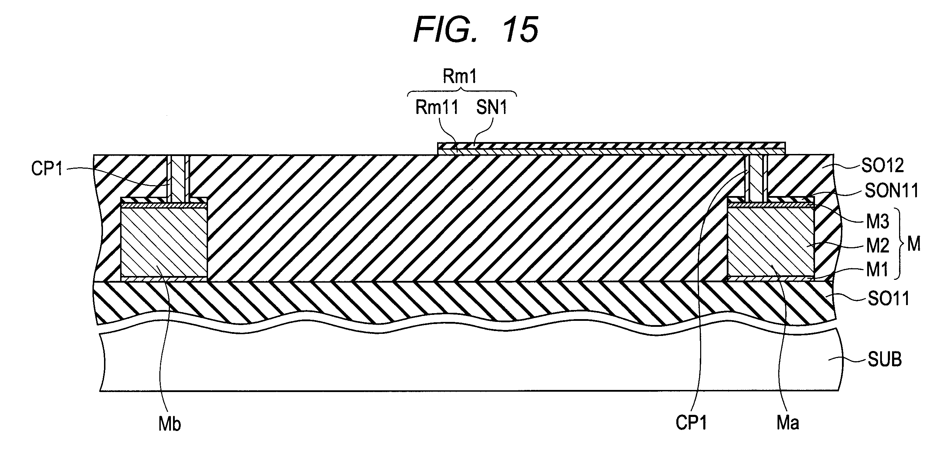

FIG. 15 is a schematic cross-sectional view showing a sixth step of the method for manufacturing the semiconductor device in accordance with the first embodiment. Referring to FIG. 15, over the second interlayer insulation film SO12, a metal resistance element layer Rm1 is formed. The metal resistance element layer Rm1 has a double-layer structure having the metal resistance film layer Rm11 and the antioxidant film layer SN1. For example, the metal resistance film layer Rm11 is a TiN film formed by a sputtering method.

For the antioxidant film layer SN1, for example, a plasma nitride (P-SiN) film is used. The plasma nitride film is formed by a CVD method.

Then, using a photolithographic technology and a dry etching treatment, patterning of the metal resistance element layer Rm1 is performed. By this step, the metal resistance element layer Rm1 is formed, and the metal resistance element layer Rm1 is electrically coupled with the tap layer Ma via the contact plug CP1.

Incidentally, the antioxidant film layer SN1 prevents the surface of the metal resistance film layer Rm11 from being exposed to an oxygen plasma atmosphere when resist removal is performed in the oxygen plasma atmosphere.

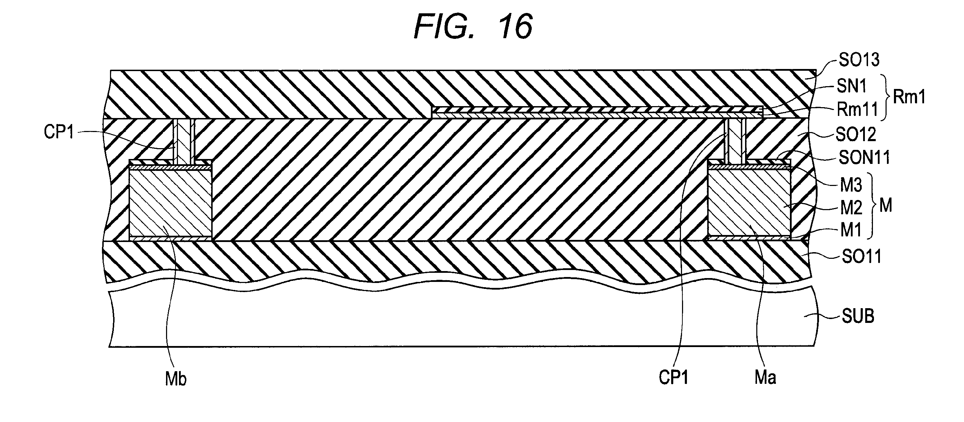

FIG. 16 is a schematic cross-sectional view showing a seventh step of the method for manufacturing the semiconductor device in accordance with the first embodiment. Referring to FIG. 16, over the second interlayer insulation film SO12, the third interlayer insulation film SO13 is formed in such a manner as to cover the metal resistance element layer Rm1. For the third interlayer insulation film SO13, a silicon oxide film including a P-TEOS film is used. The P-TEOS film is formed by a CVD method. Further, a planarization treatment using a CMP method is performed. As a result, the surface of the third interlayer insulation film SO13 is planarized.

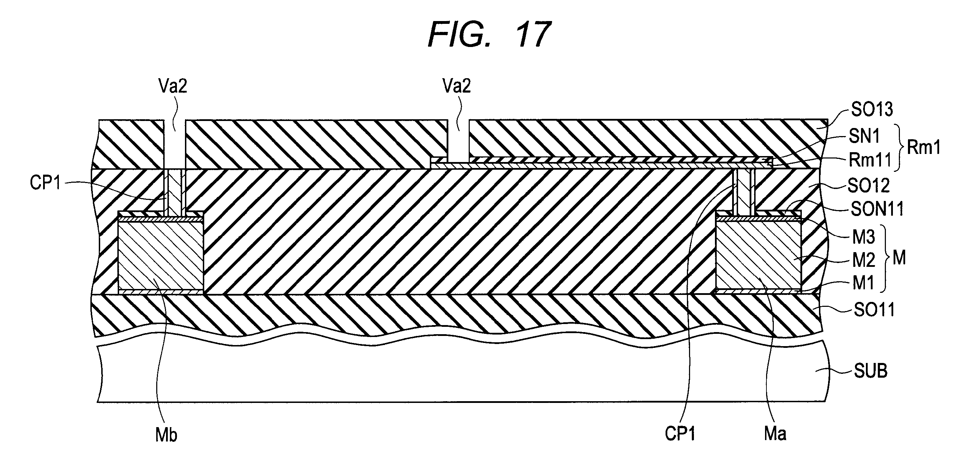

FIG. 17 is a schematic cross-sectional view showing an eighth step of the method for manufacturing the semiconductor device in accordance with the first embodiment. Referring to FIG. 17, using a photolithographic technology and a dry etching treatment, contact holes Va2 are formed in the third interlayer insulation film SO13. Over the tap layer Mb, the contact hole Va2 is formed in the third interlayer insulation film SO13 in such a manner as to communicate with the contact plug CP1. Further, the contact hole Va2 is formed in the third interlayer insulation film SO13 in such a manner as to communicate with the metal resistance film layer Rm11.

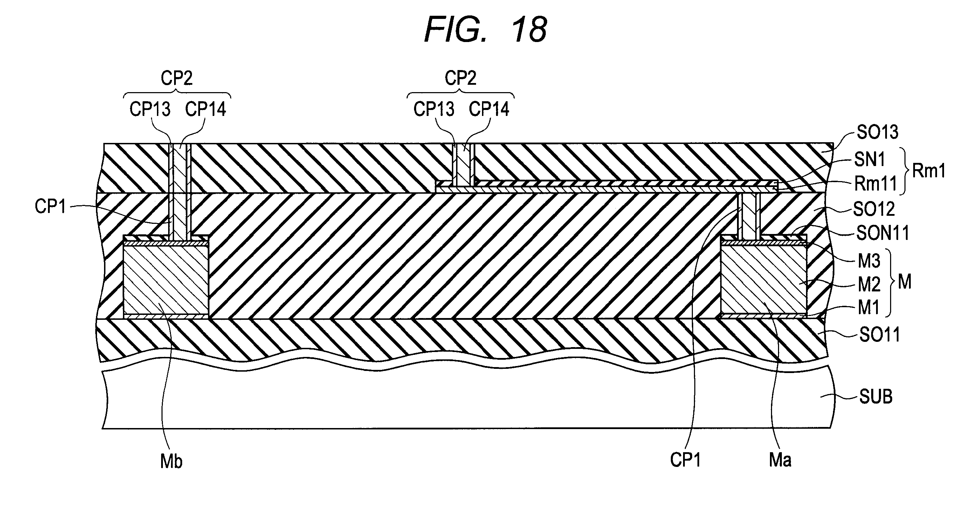

FIG. 18 is a schematic cross-sectional view showing a ninth step of the method for manufacturing the semiconductor device in accordance with the first embodiment. Referring to FIG. 18, in the contact holes Va2, contact plugs CP2 are formed. First, a TiN/Ti lamination film CP13 as a barrier metal is deposited in the contact hole Va2 by a sputtering method. Then, a tungsten film CP14 is deposited by a CVD method. Subsequently, by a CMP method, the top surfaces of the TiN/Ti lamination film CP13 and the tungsten film CP14 are planarized.

Over the tap layer Mb, the contact plug CP1 and the contact plug CP2 are coupled. As a result, the contact plug CP3 is formed.

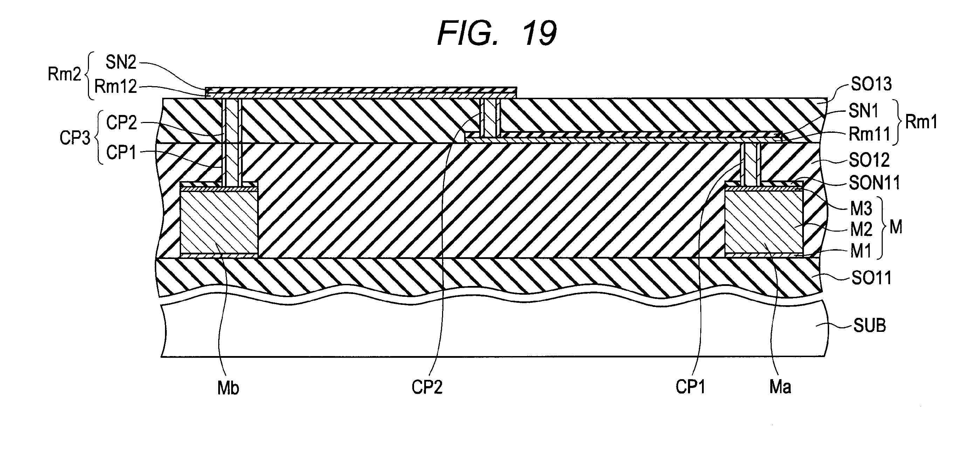

FIG. 19 is a schematic cross-sectional view showing a tenth step of the method for manufacturing the semiconductor device in accordance with the first embodiment. Referring to FIG. 19, over the third interlayer insulation film SO13, a metal resistance element layer Rm2 is formed. The metal resistance element layer Rm2 has a double-layer structure having the metal resistance film layer Rm12 and the antioxidant film layer SN2. For example, the metal resistance film layer Rm12 is a TaN film formed by a sputtering method. However, as described above, the metal resistance film layer Rm11 may be a TaN film, and the metal resistance film layer Rm12 may be a TiN film. The metal resistance element layer Rm2 is electrically coupled with the tap layer Ma via the contact plug CP2.

Then, using a photolithographic technology and a dry etching treatment, patterning of the metal resistance element layer Rm2 is performed. By this step, the metal resistance element layer Rm2 is formed. For the antioxidant film layer SN2, a plasma nitride (P-SiN) film is used. The plasma nitride film is formed by a CVD method. The antioxidant film layer SN2 prevents the surface of the metal resistance film layer Rm12 from being exposed to an oxygen plasma atmosphere when resist removal is performed in the oxygen plasma atmosphere.

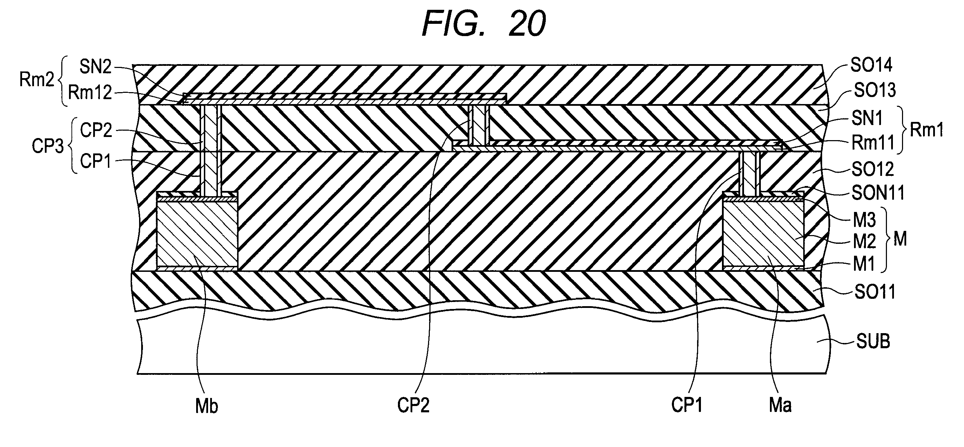

FIG. 20 is a schematic cross-sectional view showing an eleventh step of the method for manufacturing the semiconductor device in accordance with the first embodiment. Referring to FIG. 20, over the third interlayer insulation film SO13, the fourth interlayer insulation film SO14 is formed. Further, a planarization treatment using a CMP method is performed. As a result, the surface of the fourth interlayer insulation film SO14 is planarized.

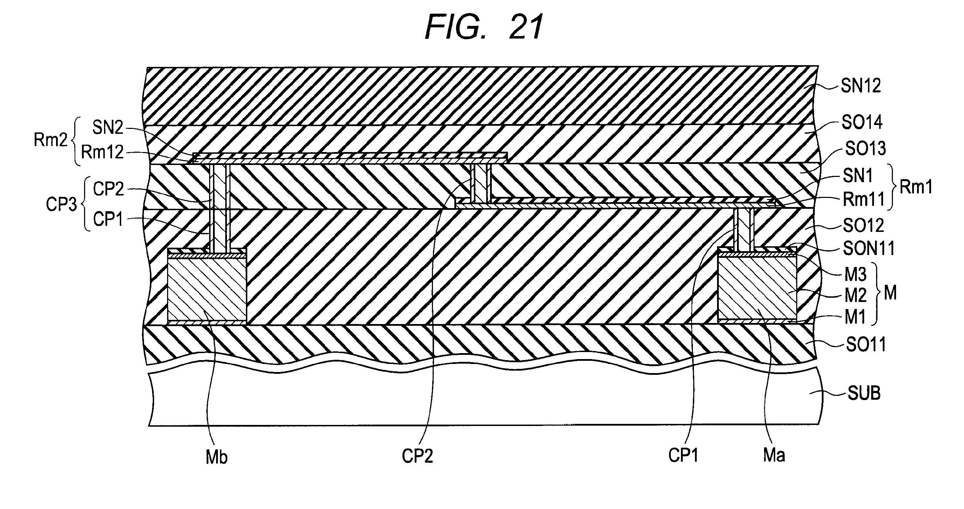

FIG. 21 is a schematic cross-sectional view showing a twelfth step of the method for manufacturing the semiconductor device in accordance with the first embodiment. Referring to FIG. 21, over the fourth interlayer insulation film SO14, a passivation film SN12 is formed. For the passivation film SN12, a P-SiN film is used. The passivation film SN12 is deposited by a CVD method. The passivation film SN12 is a coating film for protecting the surface of the semiconductor device from external damages. Incidentally, although not shown in FIG. 21, in order to form pad openings, the second interlayer insulation film SO12, the third interlayer insulation film SO13, the fourth interlayer insulation film SO14, and the passivation film SN12 are selectively removed by a photolithographic technology and a dry etching treatment.

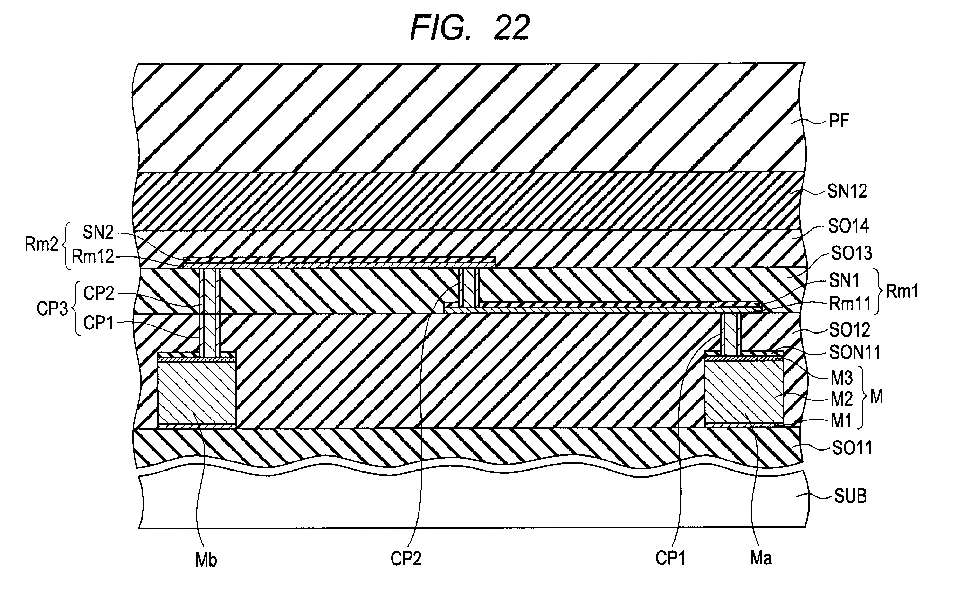

FIG. 22 is a schematic cross-sectional view showing a thirteenth step of the method for manufacturing the semiconductor device in accordance with the first embodiment. Referring to FIG. 22, over the passivation film SN12, a protective film PF is formed. The protective film PF is, for example, a photosensitive polyimide film. Incidentally, although not shown in FIG. 22, a pattern obtained by removing polyimide covering the pad openings formed by the previous step is formed by a photolithographic treatment. By the steps up to this point, the semiconductor device shown in FIGS. 7 and 8 is completed.

In this embodiment, the metal resistance element layers Rm1 and Rm2 are formed further above the wiring layer M arranged at the highest position of a plurality of wiring layers via the insulation film. In order to achieve favorable coverage of the passivation film SN12 and the protective film PF, respective surfaces of the second interlayer insulation film SO12 and the third interlayer insulation film SO13 are planarized. Therefore, it is possible to equalize the thicknesses of the metal resistance film layer Rm11 and the metal resistance film layer Rm12 formed by a sputtering method. The thicknesses of the metal resistance film layer Rm11 and the metal resistance film layer Rm12 can be controlled with high precision. Accordingly, it is possible to enhance the precision of respective resistance values of the resistance elements 111 and 112.

Further, by disposing the metal resistance element layers Rm1 and Rm2 above the wiring layer M, it is possible to ease restrictions on the layout of the resistance elements 111 and 112. For example, in order to obtain a desirable resistance value, there may arise a necessity of elongating the resistance element. When the metal resistance element layers Rm1 and Rm2 are formed using the wiring layer M, or a wiring layer arranged below the wiring layer M, the chip area may increase due to elongation of the resistance element for obtaining a desirable resistance value. In accordance with this embodiment, it is possible to ease restrictions on the layout of the resistance elements 111 and 112. For this reason, it is possible to form the resistance element without increasing the chip area.

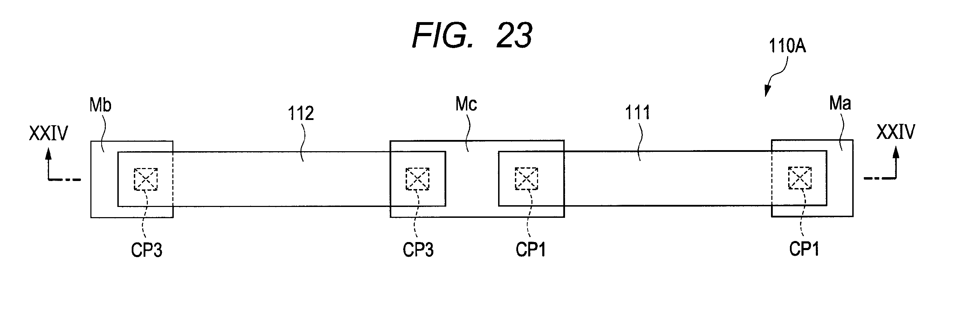

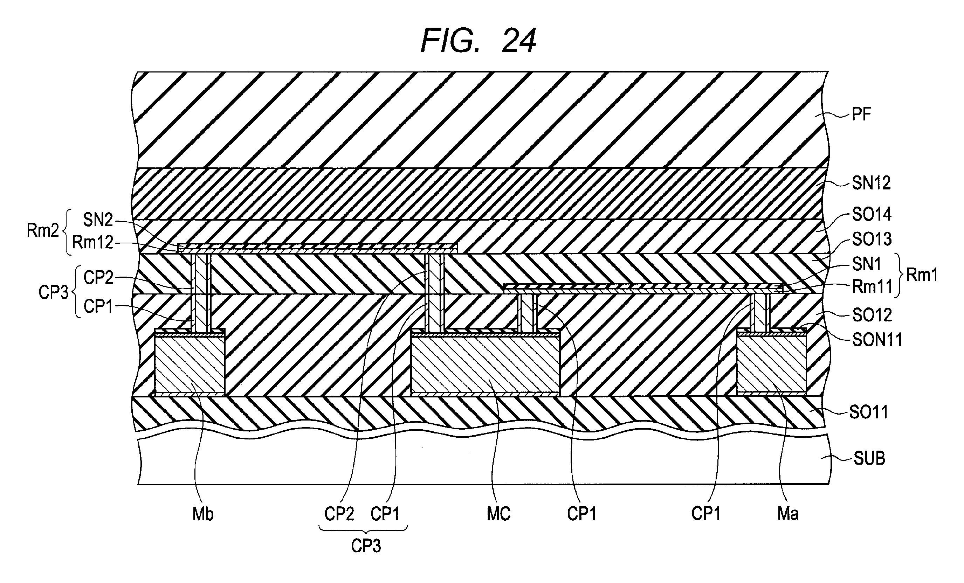

FIG. 23 is a plan view showing a first modified example of the resistance element in accordance with the first embodiment. FIG. 24 is a cross-sectional view along line XXIV-XXIV of FIG. 23. Referring to FIGS. 23 and 24, in a resistance element 110A, a resistance element 111 and a resistance element 112 are coupled to each other via a tap layer Mc and contact plugs CP1 and CP3. In this respect, the resistance element 110A is different from the resistance element 110. The configuration of other portions of the resistance element 110A is the same as the configuration of the corresponding portions of the resistance element 110. Therefore, a detailed description thereon will not be repeated hereinafter.

The tap layer Mc is, as with the tap layers Ma and Mb, the wiring layer M arranged at the highest position of a plurality of wiring layers. As shown in FIGS. 23 and 24, using the wiring layer M arranged at the highest position of a plurality of wiring layers, the resistance element 111 and the resistance element 112 can also be coupled in series to each other.

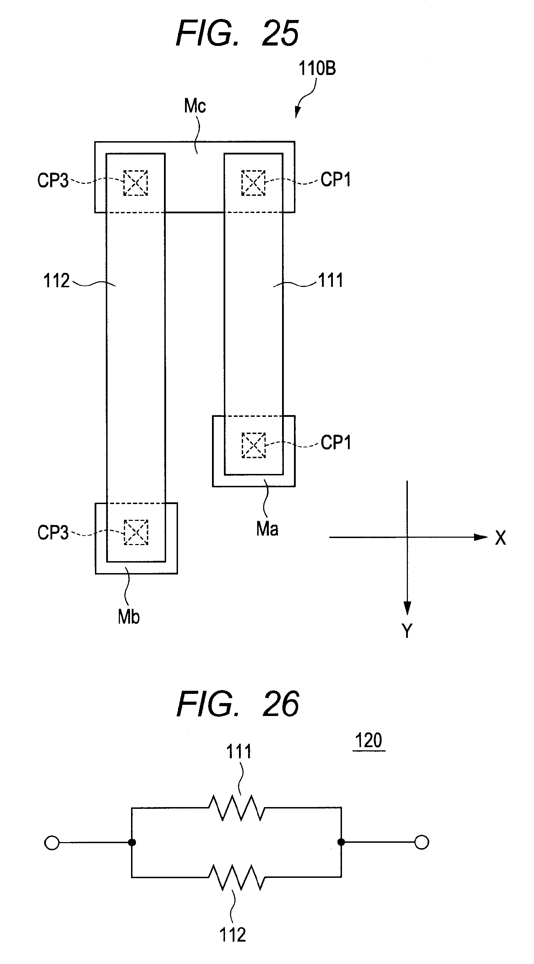

FIG. 25 is a plan view showing a second modified example of the resistance element in accordance with the first embodiment. Referring to FIG. 25, the resistance elements 111 and 112 are disposed along a given direction (which is referred to as an X direction), and extend from the tap layer Mc in the common direction (Y direction). In this respect, the resistance element 110B is different from the resistance element 110A. The configuration of other portions of the resistance element 110A is the same as the configuration of the corresponding portions of the resistance element 110. Therefore, a detailed description thereon will not be repeated hereinafter.

The metal resistance element layers Rm1 and Rm2 are disposed at a position above the wiring layer M. Therefore, as shown in FIGS. 7, 23, and 25, various layouts of the resistance elements 111 and 112 can be implemented.

Namely, the layouts shown in FIGS. 7, 23, and 25 are one examples, and other layouts can also be adopted.

As described up to this point, in accordance with the first embodiment, the semiconductor device includes a resistance element including a titanium nitride (TiN) resistance and a tantalum nitride (TaN) resistance coupled in series to each other. The titanium nitride resistance and the tantalum nitride resistance are small in temperature coefficient of the resistance value (several hundred ppm, as one example, 400 ppm). Further, the resistance value of the titanium nitride resistance has a positive temperature coefficient. On the other hand, the resistance value of the tantalum nitride resistance has a negative temperature coefficient. By combining the titanium nitride resistance and the tantalum nitride resistance, it is possible to provide a resistance element having a small temperature dependence, or substantially not having a temperature dependence.

Second Embodiment

In a second embodiment, a semiconductor device includes a resistance element including a titanium nitride resistance and a tantalum nitride resistance coupled in parallel to each other. In this respect, the second embodiment is different from the first embodiment. As with the first embodiment, this resistance element is included in a high-speed OCO circuit included in, for example, a microcomputer chip (see FIGS. 1 and 2). Accordingly, a detailed description on the high-speed OCO circuit including the resistance element in accordance with the second embodiment, and the microcomputer chip including the high-speed OCO circuit will not be repeated hereinafter.

FIG. 26 is an equivalent circuit diagram of a resistance element in accordance with the second embodiment. Referring to FIG. 26, a resistance element 120 includes resistance elements 111 and 112 coupled in parallel to each other. As with the first embodiment, the resistance element 111 is one of a titanium nitride resistance and a tantalum nitride resistance, and the resistance element 112 is the other of a titanium nitride resistance and a tantalum nitride resistance.

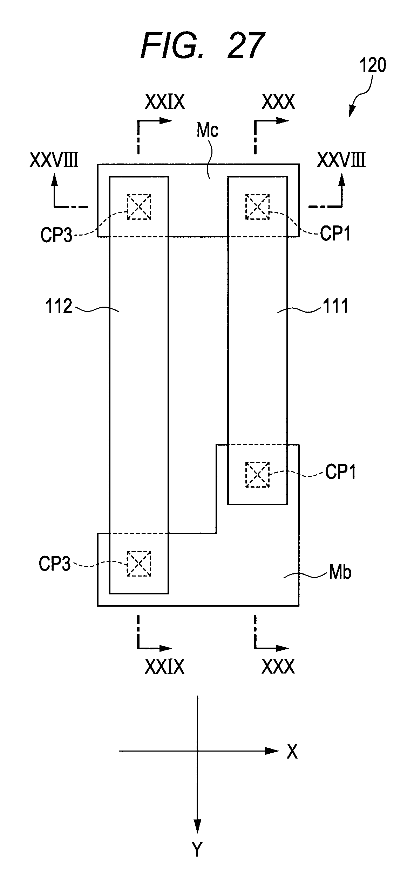

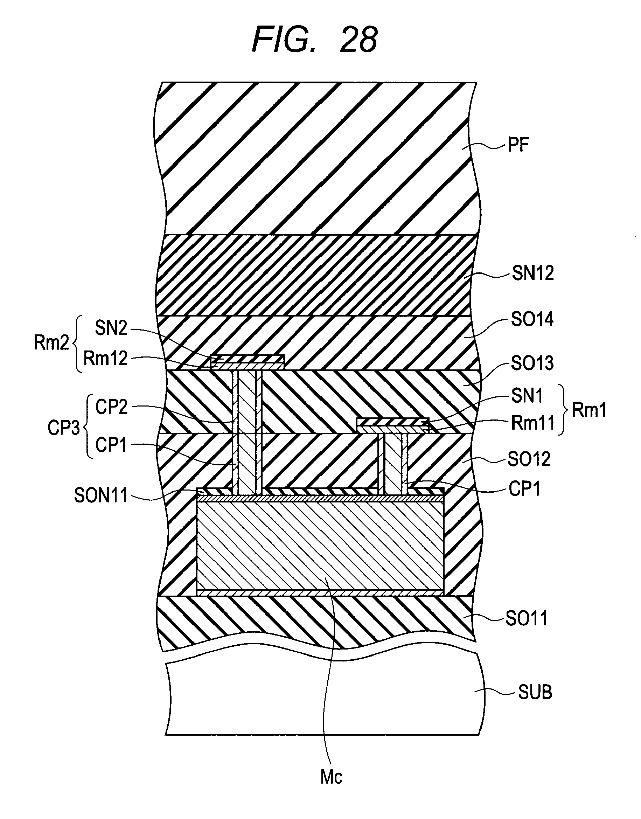

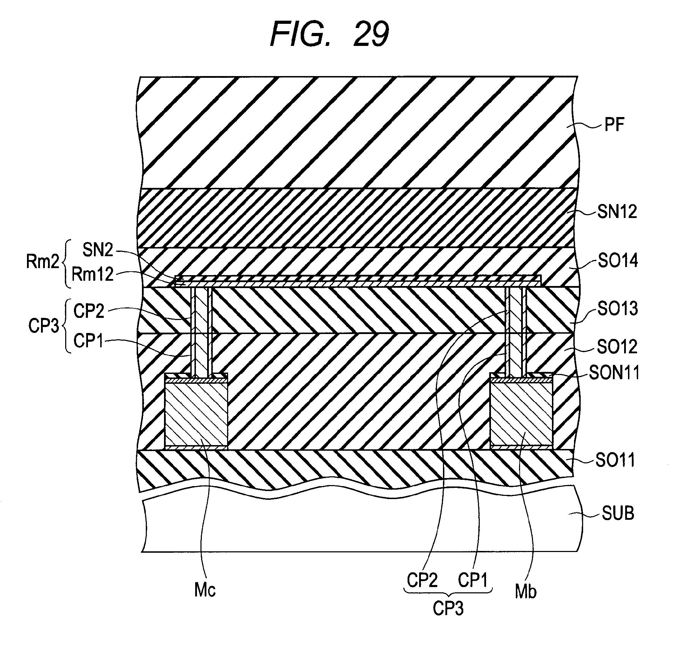

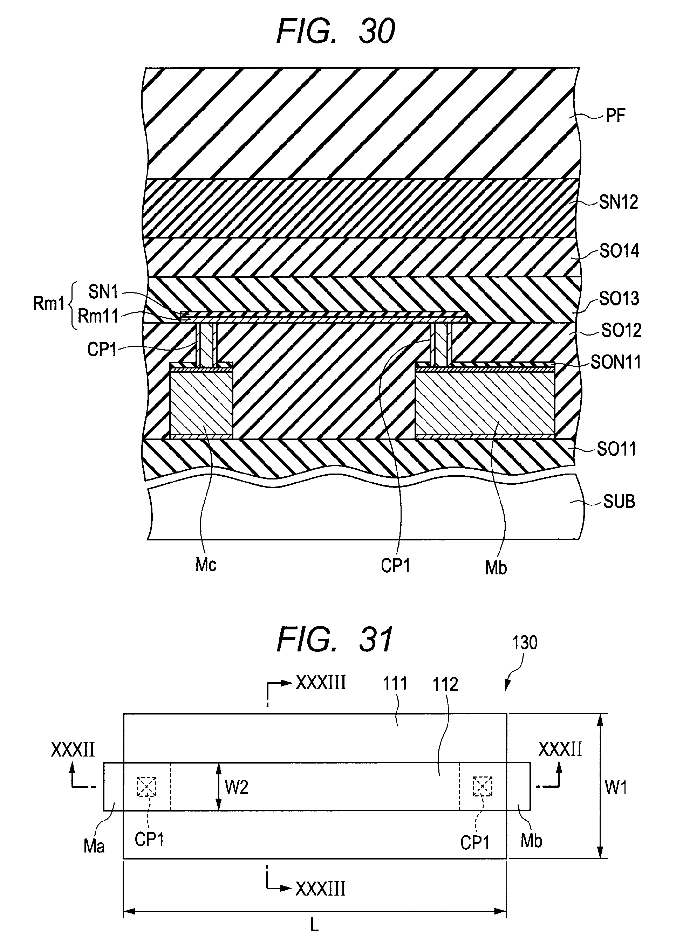

FIG. 27 is a plan view showing one example of the resistance element in accordance with the second embodiment. FIG. 28 is a cross-sectional view along line XXVIII-XXVIII of FIG. 27. FIG. 29 is a cross-sectional view along line XXIX-XXIX of FIG. 27. FIG. 30 is a cross-sectional view along line XXX-XXX of FIG. 27.

Referring to FIGS. 27 to 30, the resistance element 120 has the resistance element 111 and the resistance element 112. The one end of the resistance element 111 is coupled to the tap layer Mb via the contact plug CP3. The other end of the resistance element 111 is coupled to a tap layer Mc via the contact plug CP1. The one end of the resistance element 112 is coupled to the tap layer Mb via the contact plug CP1. The other end of the resistance element 112 is coupled to the tap layer Mc via the contact plug CP1.

Incidentally, as indicated from the comparison between FIG. 27 and FIG. 25, the resistance element 120 has a configuration according to the resistance element 110B in which the tap layer Ma and the tap layer Mb are coupled to each other.

The resistance value of the resistance element 111 is referred to as R1. The resistance value of the resistance element 112 is referred to as R2. The resistance value R of the resistance element 120 is expressed according to the following expression (2). $R=1/(1/R1+1/R2)=R1*R2/(R1+R2)=\{R1s(1+\Delta R1)*R2s(1+\Delta R2)\}/\{R1s(1+\Delta R1)+R2s(1+\Delta R2)\}\approx (R1s*R2s+\Delta R1*R1s+\Delta R2*R2s)/(R1s+R2s+\Delta R1/R1s+\Delta R2*R2s)=(1+\Delta R1/R2s+\Delta R2/R1s)/(1/R2s+1/R1s+\Delta R1/R2s+\Delta R2/R1s)$ ...(2), where $\Delta R1$ and $\Delta R2$ are values having mutually opposite signs (e.g., $\Delta R1$ is a positive value, and $\Delta R2$ is a negative value). By setting the resistance values R1 and R2 at proper values, it is possible to satisfy the relationship of $\Delta R1/R2s+\Delta R2/R1s=0$. As a result, it is possible to obtain a temperature-independent resistance value R.

As described up to this point, in accordance with the second embodiment, the semiconductor device includes a resistance element including a titanium nitride resistance and a tantalum nitride resistance coupled in parallel to each other. As with the first embodiment, in accordance with the second embodiment, it is possible to reduce the temperature dependence, or to make substantially zero the temperature dependence also in the resistance element formed by parallel coupling.

Third Embodiment

In a third embodiment, a titanium nitride resistance and a tantalum nitride resistance are stacked. In this respect, the third embodiment is different from the first embodiment. As with the first embodiment, this resistance element is included in a high-speed OCO circuit included in a microcomputer chip (see FIGS. 1 and 2). Accordingly, a detailed description on the high-speed OCO circuit including the resistance element in accordance with the third embodiment, and a microcomputer chip including the high-speed OCO circuit will not be repeated hereinafter.

FIG. 31 is a plan view showing one example of the resistance element in accordance with the third embodiment. Referring to FIG. 31, a resistance element 130 includes a resistance element 111 and a resistance element 112 disposed over the resistance element 111. The one end of the resistance element 111 is coupled to the tap layer Ma via the contact plug CP1. The other end of the resistance element 111 is coupled to the tap layer Mb via the contact plug CP1.

The length of the resistance element 111 and the length of the resistance element 112 are both L. The width of the resistance element 111 is W1. In contrast, the width of the resistance element 112 is W2. W1 < W2. As with the first and second embodiments, the resistance element 111 is one of the titanium nitride resistance and the tantalum nitride resistance. The resistance element 112 is the other of the titanium nitride resistance and the tantalum nitride resistance.

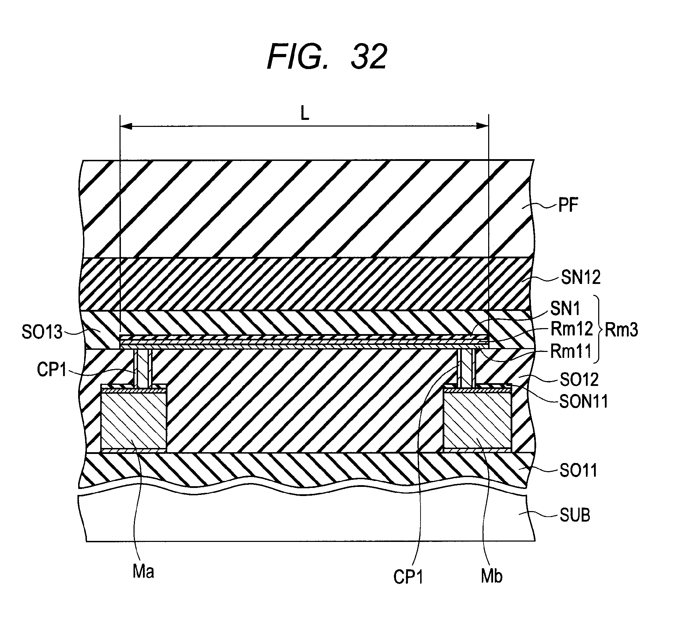

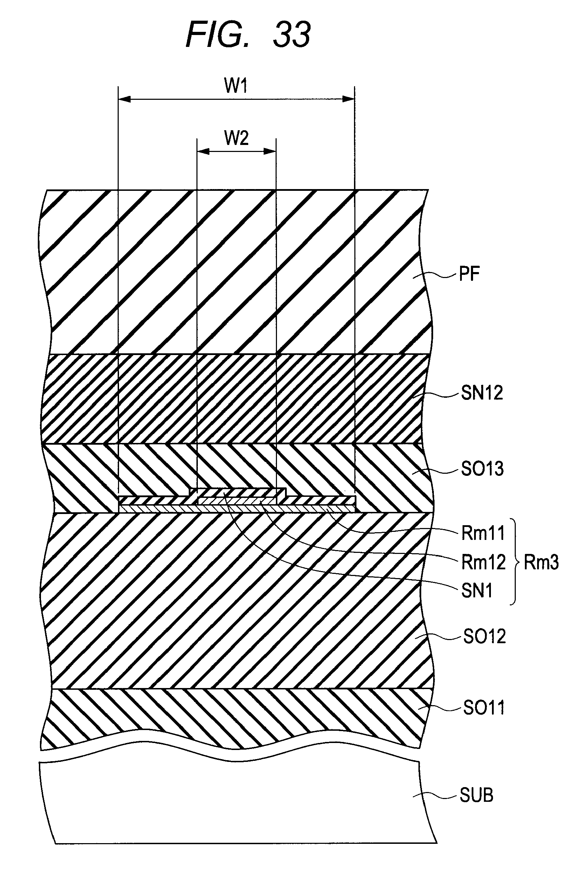

FIG. 32 is a cross-sectional view along line XXXII-XXXII of FIG. 31. FIG. 33 is a cross-sectional view along line XXXIII-XXXIII of FIG. 31. Referring to FIGS. 32 and 33, over the second interlayer insulation film SO12, a metal resistance element layer Rm3 is provided. The metal resistance element layer Rm3 has a three-layer structure of metal resistance film layers Rm11 and Rm12, and an antioxidant film layer SN1. The metal resistance film layer Rm12 is stacked over the metal resistance film layer Rm11. The metal resistance film layer Rm11 corresponds to the resistance element 111. The metal resistance film layer Rm12 corresponds to the resistance element 112. The antioxidant film layer SN1 covers the metal resistance film layers Rm11 and Rm12.

The metal resistance element layer Rm3 is covered with the third interlayer insulation film SO13. The semiconductor device in accordance with the third embodiment does not have a fourth interlayer insulation film SO14. In this respect, the semiconductor device in accordance with the third embodiment is different from the semiconductor device in accordance with the first embodiment (see FIG. 8). The third interlayer insulation film SO13 is covered with the flat-surface passivation film SN12. The passivation film SN12 is covered with the flat-surface protective film PF.

The configuration of other portions of the semiconductor device shown in FIGS. 32 and 33 is the same as the configuration of the corresponding portions of the semiconductor device in accordance with the first embodiment (see FIG. 8). Namely, as with the first embodiment, the metal resistance film layers Rm11 and Rm12 are arranged above the wire of the highest layer of a plurality of wiring layers.

The metal resistance film layer Rm11 is one of the titanium nitride resistance and the tantalum nitride resistance. The metal resistance film layer Rm12 is the other of the titanium nitride resistance and the tantalum nitride resistance. Namely, the titanium nitride resistance may be formed above the tantalum nitride resistance. Conversely, the tantalum nitride resistance may be formed above the titanium nitride resistance.

The methods for manufacturing the metal resistance element layer Rm3 have no particular restriction. However, for example, the method described below can be employed. First, over the planarized surface of the second interlayer insulation film SO12, a TiN film (metal resistance film layer Rm11) is formed by a sputtering method. Then, using a photolithographic technology and a dry etching treatment, patterning of the metal resistance film layer Rm11 is performed.

Subsequently, by a sputtering method, a TaN film (metal resistance film layer Rm12) is formed. Using a photolithographic technology and a dry etching treatment, patterning of the metal resistance element layer Rm2 is performed so that the TaN film and the TiN film are stacked one over another. The TaN film may be stacked over the TiN film by a lift-off method. Namely, patterning of a photoresist is performed using a photolithographic technology so that an opening of the photoresist (space pattern) is formed at a portion thereof overlapping the TiN film. Then, the TaN film is deposited by sputtering. Finally, the photoresist is removed. As a result, it is possible to stack the TaN film having a length L and a width W2 over the TiN film.

Subsequently, the antioxidant film layer SN1 (P-SiN film) is formed by a CVD method. Using a photolithographic technology and a dry etching treatment, patterning of the antioxidant film layer SN1 is performed. Specifically, patterning of the antioxidant film layer SN1 is performed so that the length of the antioxidant film layer SN1 is L, and so that the width of the antioxidant film layer SN1 is W1.

The equivalent circuit of the resistance element 120 shown in FIGS. 31 to 33 is equal to the circuit shown in FIG. 26. Namely, the resistance element 120 includes the resistance elements 111 and 112 coupled in parallel to each other.

The resistance value of the resistance element 111 is referred to as R1. The resistance value of the resistance element 112 is referred to as R2. The resistance value R of the resistance element 110 can be expressed as $1/\{(1/R1)+(1/R2)\}=R1*R2/(R1+R2)$ as described above. When $R1=R1s(1+\Delta R1)$, and $R2=R2s(1+\Delta R2)$, the resistance value R can be expressed according to the following expression (3).

[Mathematical Expression 1]

$$R = \frac{R1s(1+\Delta R1)*R2s(1+\Delta R2)}{R1s(1+\Delta R1)+R2s(1+\Delta R2)}$$

$$= \frac{R1s*R2s(1+\Delta R1)(1+\Delta R2)}{R1s+R2s+R1s\Delta R1+R2s\Delta R2}$$

$$= \frac{R1s*R2s(1+\Delta R1)(1+\Delta R2)}{(R1s+R2s)\left(1+\dfrac{R1s\Delta R1+R2s\Delta R2}{R1s+R2s}\right)} \qquad \cdots(3)$$

The term of ΔR1*ΔR2 included in the numerator of the fraction is omitted. Further, the denominator is Taylor-expanded, resulting in transposition to the numerator. As a result, the above (3) is transformed as follows.

[Mathematical Expression 2]

$$\approx \frac{R1s*R2s}{R1s+R2s}(1+\Delta R1+\Delta R2)\left(1-\frac{R1s\Delta R1+R2s\Delta R2}{R1s+R2s}\right)$$

$$\approx \frac{R1s*R2s}{R1s+R2s}\left(1+\Delta R1+\Delta R2-\frac{R1s\Delta R1+R2s\Delta R2}{R1s+R2s}\right)$$

$$= \frac{R1s*R2s}{R1s+R2s}\left(1+\frac{R1s\Delta R1+R2s\Delta R1+R1s\Delta R2+R2s\Delta R2-R1s\Delta R1-R2s\Delta R2}{R1s+R2s}\right)$$

$$= \frac{R1s*R2s}{R1s+R2s}\left(1+\frac{R2s\Delta R1+R1s\Delta R2}{R1s+R2s}\right) \qquad \cdots(4)$$

By setting the second term inside the parentheses on the right-hand side of the above (4) to zero, it is possible to eliminate the temperature dependence of the resistance value R. Namely, the conditions such that R2*ΔR1+R1*ΔR2=0 becomes necessary.

When the resistance elements 111 and 112 are equal in resistance length, and the resistance elements 111 and 112 are different in width as shown in FIGS. 31 and 32, the conditions such that R2*ΔR1+R1*ΔR2=0 are determined in the following manner.

The sheet resistance value of the resistance element 111 is referred to as p1; the resistance length of the resistance element 111 is referred as L1; and the width of the resistance element 111 is referred to as W1. The sheet resistance value of the resistance element 112 is referred to as p2; the resistance length of the resistance element 112 is referred to as L2; and the width of the resistance element 112 is referred to as W2. The resistance value R1 of the resistance element 111 is expressed as R1=p1*(L1/W1), and the resistance value R2 of the resistance element 112 is expressed as R2=p2* (L2/W2) . Therefore, R2*ΔR1+R1*ΔR2=0 can be replaced with the following (5).

[Mathematical Expression 3]

$$\rho 2 * \frac{L2}{W2} * \Delta R1 + \rho 1 * \frac{L1}{W1} * \Delta R2 = 0 \qquad \cdots (5)$$

Herein, L1=L2. Therefore, the above (5) can be transformed as follows.

[Mathematical Expression 4]

$$\rho 2 * \frac{L2}{W2} * \Delta R1 = -\rho 1 * \frac{L1}{W1} * \Delta R2$$

$$\frac{\rho 2 * \Delta R1}{W2} = -\frac{\rho 1 * \Delta R2}{W1}$$

$$\frac{W1}{W2} = -\frac{\rho 1 * \Delta R2}{\rho 2 * \Delta R1} \qquad \cdots (6)$$

Therefore, by setting the ratio of W1 and W2 so as to satisfy the relationship shown in the above (6), it is possible to eliminate the temperature dependence of the resistance value R.

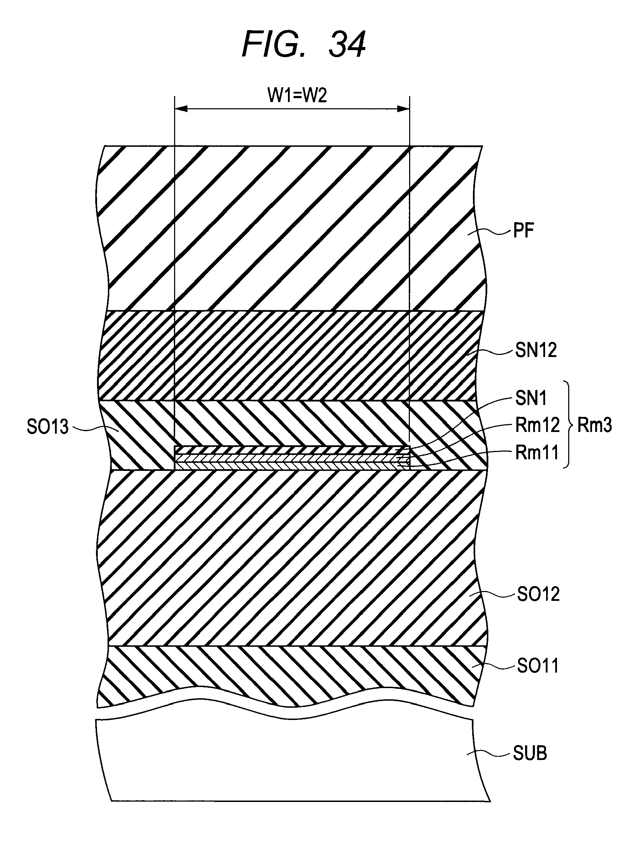

Further, as shown in FIG. 34, it is also possible to equalize the widths of the metal resistance film layers Rm11 and Rm12 (i.e., the width W1 of the resistance element 111 and the width W2 of the resistance element 112). For example, a TiN film is manufactured by sputtering, and the target is changed to continuously perform sputtering. As a result, the TaN film is stacked over the TiN film. Further, by a CVD method, an antioxidant film layer SN1 is manufactured in such a manner as to cover the TaN film and the TiN film. Subsequently, it is possible to manufacture the resistance element 111 and the resistance element 112 having the same width as shown in FIG. 34 by a patterning treatment.

In this case, the conditions (R2*ΔR1+R1*ΔR2=0) for eliminating the temperature dependence of the resistance value R are determined in the following manner.

First, the sheet resistance p is expressed as ρ=σ/t, where σ denotes the volume resistance, and t denotes the film thickness. The above (5) can be transformed as follows.

[Mathematical Expression 5]

$$\frac{\sigma 2}{t2} * \frac{L2}{W2} * \Delta R1 = -\frac{\sigma 1}{t1} * \frac{L1}{W1} * \Delta R2 \qquad \cdots (7)$$

where σ1 denotes the volume resistance of the resistance element 111, t1 denotes the film thickness of the resistance element 111, σ2 denotes the volume resistance of the resistance element 112, and t2 denotes the film thickness of the resistance element 112,

L1=L2, and W1=W2. Therefore, the above (7) can be transformed as follows.

[Mathematical Expression6]

$$\frac{\sigma 2}{t2} * \Delta R1 = -\frac{\sigma 1}{t1} * \Delta R2$$

$$\frac{t1}{t2} = -\frac{\sigma 1 * \Delta R2}{\sigma 2 * \Delta R1} \qquad \cdots (8)$$

By selecting the film thicknesses t1 and t2 so as to satisfy the relationship expressed by the above (8), it is possible to obtain a resistance value R having no temperature dependence.

As described up to this point, in accordance with the third embodiment, the titanium nitride resistance and the tantalum nitride resistance are stacked one over another. This eliminates the necessity of the contact plug for mutual coupling between the titanium nitride resistance and the tantalum nitride resistance, or the contact plug for coupling each of the titanium nitride resistance and the tantalum nitride resistance to the wiring layer M (tap layer Mc shown in FIGS. 27 and 28). As a result, it is possible to reduce the proportion of contribution of the resistance value of the contact plug with respect to the resistance value of the resistance element.

As described above, the temperature coefficient of the resistance value of the contact plug may be larger than the temperature coefficient (absolute value) of each resistance value of the titanium nitride resistance and the tantalum nitride resistance. In accordance with the third embodiment, it is possible to provide a resistance element more reduced in temperature dependence than the resistance element in accordance with the first or second embodiment, or a resistance element substantially not having a temperature dependence.

Further, in accordance with the third embodiment, the fourth interlayer insulation film SO14 can be omitted from the configuration in accordance with the first embodiment. Therefore, in accordance with the third embodiment, it is possible to reduce the manufacturing cost of the semiconductor device as compared with the first embodiment.

Fourth Embodiment

A semiconductor device in accordance with a fourth embodiment includes a plurality of the resistance elements in accordance with any of the first to third embodiments, and thereby enables adjustment of the resistance value.

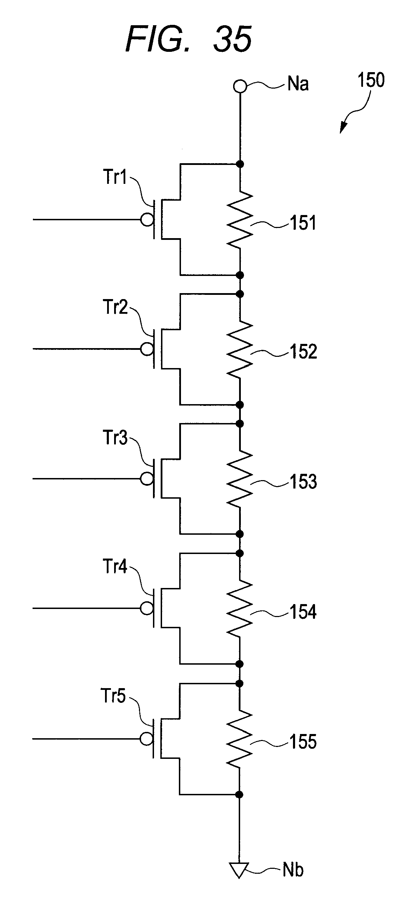

FIG. 35 is a view showing a resistance circuit included in the semiconductor device in accordance with the fourth embodiment. Referring to FIG. 35, a resistance circuit 150 includes resistance elements 151 to 155 coupled in series between a node Na and a node Nb, and MOSFETs Tr1 to Tr5 coupled in parallel to the resistance elements 151 to 155, respectively. Respective resistance elements 151 to 155 are resistance elements (110, 110A, 110B, 120, and 130) in accordance with any of the first to third embodiments.

The resistance circuit 150 can be used in place of, for example, the resistance element 110 in the constant voltage circuit 101 shown in FIG. 2. In this case, the node Na is coupled to the source of the MOSFET Q1, and the node Nb is coupled to the grounding voltage.

Each of the resistance elements 151 to 155 is selected when the corresponding MOSFET is turned off. Whereas, it is rendered in a non-selected state when the corresponding MOSFET is turned on. The MOSFETs Tr1 to TR5 are each independently turned on or off. Therefore, it is possible to control the resistance value between the node Na and the node Nb. Further, conceivably, the temperature dependence (temperature coefficient) of the resistance value varies between the resistance elements 151 to 155. Use of this enables the fine adjustment of the temperature dependence of the resistance value between the node Na and the node Nb.

Incidentally, in FIG. 35, the number of resistance elements included in the resistance circuit 150 is 5. However, the number of resistance elements included in the resistance circuit 150 has no particular restriction so long as it is plural.

Further, the resistance elements in accordance with the embodiments are not limited to those for use in an OCO circuit. The present invention is applicable to a semiconductor device including a circuit required to be minimized in variation of the resistance value according to the temperature.

The embodiments herein disclosed should be considered illustrative but not limiting in all aspects. The scope of the present invention is defined not by the description of the embodiments but the appended claims, and intended to embrace all changes that come within the meaning and range of equivalency of the claims, as interpreted by the description and drawings.

The present invention is in particular advantageously applicable to semiconductor devices having resistance elements.

**Claims**

1. A semiconductor device, comprising:

   a semiconductor substrate;
   an insulation layer provided over the semiconductor substrate;
   a first resistance element provided over the insulation layer; and
   a second resistance element electrically coupled to the first resistance element,
   wherein one of the first and second resistance elements is formed of titanium nitride, and
   wherein the other of the first and second resistance elements is formed of tantalum nitride.

2. The semiconductor device according to claim 1, further comprising a plurality of wiring layers,
   wherein the first and second resistance elements are disposed over the wiring layer arranged at the highest position
   of the wiring layers via the insulation layer.

3. The semiconductor device according to claim 1, wherein the second resistance element is coupled in series to the
   first resistance element.

4. The semiconductor device according to claim 1, wherein the second resistance element is coupled in parallel to the
   first resistance element.

5. The semiconductor device according to claim 1,
   wherein the second resistance element is stacked over the first resistance element such that the second resistance
   element is in direct contact with the first resistance element.

6. The semiconductor device according to claim 1, wherein the first and second resistance elements are included in
   a constant voltage circuit for generating a constant voltage by flow of a constant current through the first and second
   resistance elements.

7. The semiconductor device according to claim 6, wherein the constant voltage circuit includes:

   a plurality of resistance elements each comprising the first and second resistance elements, and electrically
   coupled to one another; and
   a plurality of transistors respectively coupled to the resistance elements.

8. The semiconductor device according to claim 6, wherein the constant voltage circuit is included in an oscillation circuit.

9. The semiconductor device according to claim 8, wherein the oscillation circuit is included in a chip of a microcomputer.

# FIG. 1

MC11

100

MC1

RAM
(SRAM)

OCO

POWER
SUPPLY CIRCUIT

MC16

PERIPHERAL
CIRCUIT

MC12

CPU

MC15

PERIPHERAL
CIRCUIT

ROM
(Flash)

MC14

MC13    SP

# FIG. 2

# FIG. 3

## FIG. 4

## FIG. 5

# FIG. 6

110

# FIG. 7

110

FIG. 8

EP 2 434 530 A2

FIG. 9

SO3
SO2
SO1

ML2
ML1

SUB

FIG. 10

SON11
M3
M2 } M
M1
SO11

SUB

## FIG. 11

EP 2 434 530 A2

FIG. 12

EP 2 434 530 A2

## FIG. 13

# FIG. 14

*FIG. 15*

EP 2 434 530 A2

EP 2 434 530 A2

# FIG. 16

## FIG. 17

EP 2 434 530 A2

EP 2 434 530 A2

## FIG. 18

FIG. 19

FIG. 20

EP 2 434 530 A2

EP 2 434 530 A2

## FIG. 21

EP 2 434 530 A2

## FIG. 22

EP 2 434 530 A2

# FIG. 23

## FIG. 24

EP 2 434 530 A2

## FIG. 25

## FIG. 26

## FIG. 27

## FIG. 28

PF

SN12

SO14

Rm2 { SN2
Rm12 }

SO13

CP3 { CP2
CP1 }

SN1 } Rm1
Rm11 }

SON11

SO12

CP1

SO11

SUB

Mc

# FIG. 29

## FIG. 30

PF

SN12

SO14

SO13

SO12

SON11

SO11

SUB

Rm1 { SN1
Rm11

CP1

Mc            CP1            Mb

## FIG. 31

130

XXXIII        111    112

XXXII                              XXXII

W2                              W1

Ma

CP1                        CP1        Mb

XXXIII

L

## FIG. 32

# FIG. 33

## FIG. 34

# FIG. 35

**REFERENCES CITED IN THE DESCRIPTION**

**Patent documents cited in the description**

- JP 2010217317 A
- JP 2007149965 A
- JP 2006216607 A